# EUROPÄISCHE PATENTSCHRIFT

(11) **EP 4 286 866 B1**
(45) Veröffentlichungstag und Bekanntmachung des Hinweises auf die Patenterteilung: **18.03.2026**
(21) Anmeldenummer: 23174645.4
(22) Anmeldetag: 22.05.2023
(51) Int. Cl.: G01R 27/20, G01R 31/364, G01R 31/69, H01R 13/66, H01M 10/42, H01M 10/48

(54) **BATTERIEPRÜFSTAND UND VERFAHREN**
BATTERY TEST STAND AND METHOD
BANC D'ESSAI DE BATTERIE ET PROCÉDÉ

(30) Priorität: 31.05.2022 DE 102022113771
(43) Veröffentlichungstag der Anmeldung: 06.12.2023
(73) Patentinhaber: Hahn Automation GmbH, 55494 Rheinböllen (DE)
(72) Erfinder: Meißner, Thomas, 56291 Pfalzfeld (DE)
(74) Vertreter: Janke Scholl Patentanwälte PartG mbB

(56) Entgegenhaltungen:
- US-A1- 2016 109 530
- US-A1- 2021 278 481
- US-A1- 2021 313 752

## Beschreibung

Die vorliegende Erfindung betrifft einen Batterieprüfstand, einen Steckverbinder für einen Batterieprüfstand und ein Verfahren.

Moderne Kraftfahrzeuge werden zunehmend mit vollständig elektromotorischem Antrieb oder Hybridantrieb ausgestattet. Dabei dient eine Batterie, die auch als Traktionsbatterie bezeichnet wird, zur Versorgung eines Elektromotors oder mehrerer Elektromotoren mit elektrischer Leistung, um das betreffende Fahrzeug mittels des Elektromotors oder mittels mehrerer Elektromotoren anzutreiben.

Während der Herstellung derartiger Batterien werden diese vielfältigen Tests unterzogen. Unter anderem findet eine Leistungsprüfung der Batterie statt, die die Funktionstüchtigkeit und Funktionssicherheit im Rahmen einer End-of-Line Prüfung sicherstellt. Dabei wird eine zu prüfende Batterie in kurzer Zeit mehrfach geladen und wieder entladen. Weiter kann die Batterie einer Hochvoltspannung von bis zu 10 Kilovolt zur Isolationsprüfung ausgesetzt werden.

Im Rahmen dieser Tests ist es entscheidend, dass zuverlässige Steckverbindungen zur Übertragung elektrischer Leistungen hergestellt werden, um die zu prüfende Batterie mit den Testvorrichtungen zu verbinden. Hierbei ist es bekannt, z.B. für jeden Pol einer Batterie einen Steckverbinder mit einem einzelnen Pin und mit einer einzelnen Kontaktbuchse bereitzustellen, wobei die Kontaktierung zwischen Pin und Kontaktbuchse die z.B. mittels Thermofühlern oder anderen Sensoren überwacht werden. Derartige Thermofühler sind jedoch störungsanfällig und aufwändig im Betrieb. Zudem sind Thermofühler nicht für Hochvolt-Tests mit Spannungen von bis zu 10 Kilovolt zugelassen, so dass für derartige Hochvolt-Tests alternative Arten einer Kontaktüberwachung verwendet werden müssen, sofern eine Kontaktüberwachung erfolgen soll.

Das Dokument US20210313752A1 offenbart einen Adapter zum Laden einer Batterie. Das Dokument US2021278481A1 offenbart eine Überwachung des Kontaktbereichs einer Steckvorrichtung. Das Dokument US2016109530A1 offenbart eine Überwachungseinrichtung für eine Mehrzahl von Batterien.

Vor diesem Hintergrund liegt der vorliegenden Erfindung die technische Problemstellung zugrunde, einen Batterieprüfstand anzugeben, der eine zuverlässige Überwachung einer Kontaktierung von Steckverbindungen ermöglicht. Weiter sollen ein Steckverbinder und ein Verfahren angegeben werden.

Gemäß einem ersten Aspekt betrifft die Erfindung einen Batterieprüfstand, mit einer Quelle zum Bereitstellen einer elektrischen Ladeleistung für eine zu prüfende Batterie, mit einer ersten Verbindung zum Verbinden eines ersten Pols der Batterie mit einem ersten Pol der Quelle, mit einer zweiten Verbindung zum Verbinden eines zweiten Pols der Batterie mit einem zweiten Pol der Quelle, wobei die erste Verbindung einen ersten Steckverbinder aufweist, wobei der erste Steckverbinder mindestens zwei Kontaktpins aufweist, wobei ein jeweiliger Kontaktpin im gesteckten Zustand jeweils in einer zugeordneten Kontaktbuchse des ersten Steckverbinders sitzt und jeder Kontaktpin mit jeder Kontaktbuchse jeweils eine elektrische Kontaktierung ausbildet, wobei die zweite Verbindung einen zweiten Steckverbinder aufweist, wobei der zweite Steckverbinder mindestens zwei Kontaktpins aufweist, wobei ein jeweiliger Kontaktpin im gesteckten Zustand jeweils in einer zugeordneten Kontaktbuchse des zweiten Steckverbinders sitzt und jeder Kontaktpin mit jeder Kontaktbuchse jeweils eine elektrische Kontaktierung ausbildet, mit einer Überwachungseinrichtung zur Überwachung aller elektrischen Kontaktierungen.

Statt für jede Verbindung einen Steckverbinder mit einem einzelnen, für die Leistungsübertragung ausreichend groß dimensionierten Kontaktpin und einer einzelnen, dem Kontaktpin zugeordneten und ausreichend groß dimensionierten Kontaktbuchse vorzusehen, wird erfindungsgemäß der Strompfad im Bereich des Steckverbinder künstlich aufgeteilt und für jede Verbindung über zwei oder mehr Kontaktierungen geleitet, um diese Kontaktierungen gezielt zu überwachen. Es wird daher bewusst eine eigentlich zu hohe Anzahl an Kontaktpins und Kontaktbuchsen für jeden Steckverbinder in Kauf genommen, um die Überwachung der betreffenden Steckverbindung zu vereinfachen und damit die Sicherheit des Batterieprüfstands zu erhöhen.

Die Überwachung aller elektrischen Kontaktierungen ermöglicht eine Früherkennung von Kontaktproblemen, bevor diese zu Produktionsausfällen, Schäden oder Brand führen. Insbesondere können schleichend fortschreitende Kontaktprobleme erkannt und frühzeitig beseitigt werden. Ein Erfolg einer Wartung ist nach einem Austausch der defekten Komponenten sofort messbar, da die Überwachung aller elektrischen Kontaktierungen erfolgt.

Wenn vorliegend von einer Quelle gesprochen wird, so kann es sich dabei um eine Quelle handeln, die auch als Senke zum Entladen einer zu prüfenden Batterie betrieben werden kann.

Gemäß einer Ausgestaltung des Batterieprüfstands ist vorgesehen, dass die Überwachungseinrichtung zum Vergleich der jeweiligen über die einzelnen elektrischen Kontaktierungen fließenden Einzelströme ausgebildet ist, wobei jeder elektrischen Kontaktierung eine Einrichtung zur Strommessung zugeordnet ist.

Es kann vorgesehen sein, dass die Überwachungseinrichtung zum Vergleich der jeweiligen an den einzelnen elektrischen Kontaktierungen gebildeten Kontaktwiderstände ausgebildet ist, wobei jeder elektrischen Kontaktierung eine Einrichtung zur Strommessung zugeordnet ist und wobei jedem Steckverbinder eine Einrichtung zur Spannungsmessung zugeordnet ist.

Insbesondere können daher die Einzelströme aller Kontaktierungen eines jeweiligen Steckverbinders überwacht werden.

Im gesteckten zugeschalteten Zustand lässt sich die Symmetrie der Stromverteilung aller Kontaktierungen eines jeweiligen Steckverbinders und optional für jede Kontaktierungen der Kontaktwiderstand und die abfallende Leistung berechnen. Überschreitet wahlweise oder in Kombination entweder der Betrag der Abweichung von der Symmetrie der Stromaufteilung, der Widerstand eines Stranges oder die Leistung eines Stranges eine Warnschwelle, kann dies erkannt und zum Auslösen einer Warnmeldung und/oder zum Einleiten von Gegenmaßnahmen führen. Bei Erreichen einer jeweiligen Fehlerschwelle kann z.B. der Stromfluss unterbrochen werden.

Gemäß einer Ausgestaltung des Batterieprüfstands ist vorgesehen, dass der erste Steckverbinder genau zwei Kontaktpins und genau zwei Kontaktbuchsen aufweist und/oder der zweite Steckverbinder genau zwei Kontaktpins und genau zwei Kontaktbuchsen aufweist.

Es kann vorgesehen sein, dass der erste Steckverbinder genau drei Kontaktpins und genau drei Kontaktbuchsen aufweist und/oder der zweite Steckverbinder genau drei Kontaktpins und genau drei Kontaktbuchsen aufweist.

Gemäß einer Ausgestaltung des Batterieprüfstands ist vorgesehen, dass der erste Steckverbinder bis zu zehn Kontaktpins und bis zu zehn Kontaktbuchsen aufweist und/oder der zweite Steckverbinder bis zu zehn Kontaktpins und bis zu zehn Kontaktbuchsen aufweist.

Es kann eine dritte Verbindung zum Verbinden eines dritten Pols der Batterie mit einem dritten Pol der Quelle vorgesehen sein, wobei die dritte Verbindung einen dritten Steckverbinder aufweist, wobei der dritte Steckverbinder mindestens zwei Kontaktpins aufweist, wobei ein jeweiliger Kontaktpin im gesteckten Zustand jeweils in einer zugeordneten Kontaktbuchse des dritten Steckverbinders sitzt und jeder Kontaktpin mit jeder Kontaktbuchse jeweils eine elektrische Kontaktierung ausbildet.

Gemäß einer Ausgestaltung des Batterieprüfstands ist vorgesehen, dass jeder Steckverbinder einen Stecker und einen Gegenstecker aufweist, wobei der Stecker die Kontaktpins und der Gegenstecker die Kontaktbuchsen trägt oder wobei der Gegenstecker die Kontaktpins und die Stecker die Kontaktbuchsen trägt.

Gemäß einem zweiten Aspekt betrifft die Erfindung einen Steckverbinder für einen erfindungsgemäßen Batterieprüfstand, wobei der Steckverbinder zum Verbinden eines Pols der Batterie mit einem Pol der Quelle eingerichtet ist, wobei der Steckverbinder mindestens zwei Kontaktpins aufweist, wobei ein jeweiliger Kontaktpin im gesteckten Zustand jeweils in einer zugeordneten Kontaktbuchse des Steckverbinders sitzt und jeder Kontaktpin mit jeder Kontaktbuchse jeweils eine elektrische Kontaktierung ausbildet.

Gemäß einem dritten Aspekt betrifft die Erfindung ein Verfahren, mit den Verfahrensschritten: Betreiben eines Batterieprüfstands, wobei eine Quelle zum Bereitstellen einer elektrischen Ladeleistung mit einer zu prüfenden Batterie verbunden ist, wobei eine erste Verbindung zwischen einem ersten Pol der Batterie und einem ersten Pol der Quelle ausgebildet ist, wobei eine zweite Verbindung zwischen einem zweiten Pol der Batterie und einem zweiten Pol der Quelle ausgebildet ist, wobei die erste Verbindung einen ersten Steckverbinder aufweist, wobei der erste Steckverbinder mindestens zwei Kontaktpins aufweist, wobei ein jeweiliger Kontaktpin im gesteckten Zustand jeweils in einer zugeordneten Kontaktbuchse des ersten Steckverbinders sitzt und jeder Kontaktpin mit jeder Kontaktbuchse jeweils eine elektrische Kontaktierung ausbildet, wobei die zweite Verbindung einen zweiten Steckverbinder aufweist, wobei der zweite Steckverbinder mindestens zwei Kontaktpins aufweist, wobei ein jeweiliger Kontaktpin im gesteckten Zustand jeweils in einer zugeordneten Kontaktbuchse des zweiten Steckverbinders sitzt und jeder Kontaktpin mit jeder Kontaktbuchse jeweils eine elektrische Kontaktierung ausbildet; Überwachen aller elektrischen Kontaktierungen mittels einer Überwachungseinrichtung.

Nachfolgend wird die Erfindung anhand von Ausführungsbeispiele darstellenden Zeichnungen näher beschrieben. Es zeigen jeweils schematisch:
- Fig. 1: einen erfindungsgemäßen Steckverbinder für einen Batterieprüfstand;
- Fig. 2: einen erfindungsgemäßen Batterieprüfstand;
- Fig. 3: den erfindungsgemäßen Batterieprüfstand aus Fig. 2;
- Fig. 4: Verfahrensschritte;
- Fig. 5: Verfahrensschritte;
- Fig. 6: einen weiteren erfindungsgemäßen Batterieprüfstand;
- Fig. 7: einen weiteren erfindungsgemäßen Batterieprüfstand.

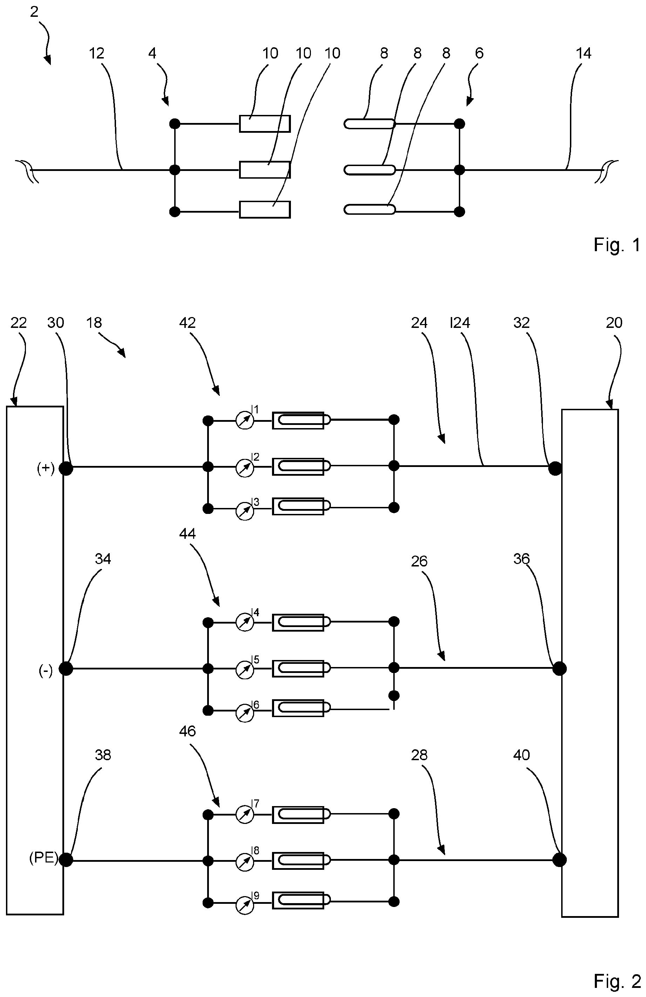

Fig. 1 zeigt einen Steckverbinder 2 für einen Batterieprüfstand. Der Steckverbinder 2 weist einen Stecker 4 und einen Gegenstecker 6 auf. Der Steckverbinder 2 ist zum Verbinden eines Pols einer zu prüfenden Batterie mit einem Pol einer Quelle eingerichtet. Wenn vorliegend von einer Quelle gesprochen wird, so handelt es sich dabei um eine Quelle zum Bereitstellen elektrischer Leistung, wie zum Beispiel eine Stromquelle, einer Spannungsquelle oder dergleichen.

Der Steckverbinder 2 hat vorliegend drei Kontaktpins 8, wobei die Kontaktpins 8 an dem Gegenstecker 6 befestigt sind. Der Steckverbinder 2 hat vorliegend drei Kontaktbuchsen 10, wobei die Kontaktbuchsen 10 an dem Stecker 4 befestigt sind.

Jeder Kontaktpin 8 bildet mit einer zugeordneten Kontaktbuchse 10 im gesteckten Zustand eine elektrische Kontaktierung aus, wobei in jeder Kontaktbuchse 10 im gesteckten Zustand ein Kontaktpin 8 sitzt. Im gesteckten Zustand hat der Steckverbinder 2 daher drei elektrische Kontaktierungen, um zwei zu verbindende Leitungen 12, 14 elektrisch leitend miteinander zu verbinden.

Fig. 2 zeigt einen Batterieprüfstand 18. Der Batterieprüfstand 18 hat eine Quelle 20 zum Bereitstellen einer elektrischen Ladeleistung für eine zu prüfende Batterie 22. Die Quelle 20 kann zudem als Senke zum Entladen der zu prüfenden Batterie 22 dienen.

Zwischen der Batterie 22 und der Quelle 20 sind eine erste Verbindung 24, eine zweite Verbindung 26 und eine dritte Verbindung 28 gebildet.

Die erste Verbindung 24 verbindet einen ersten Pol 30 der Batterie 22 mit einem ersten Pol 32 der Quelle. Die zweite Verbindung 26 verbindet einen zweiten Pol 34 der Batterie 22 mit einem zweiten Pol 36 der Quelle. Die dritte Verbindung 28 verbindet einen dritten Pol 38 der Batterie 22 mit einem dritten Pol 40 der Quelle. Bei den Polen der Batterie 22 kann es sich beispielsweise um einen Pluspol (+) einen Minuspol (-) sowie einem Pol (PE) für die Schutzerde handeln.

Die erste Verbindung weist einen ersten Steckverbinder 42 auf. Die zweite Verbindung 26 weist einen zweiten Steckverbinder 44 auf. Die dritte Verbindung 28 weist einen dritten Steckverbinder 46 auf. Die Steckverbinder 42, 44, 46 sind baugleich zu dem voranstehend mit Bezug zu Fig. 1 beschriebenen Steckverbinder 2 ausgebildet. Dementsprechend weist jeder der Steckverbinder 42, 44, 46 drei Kontaktpins auf, die jeweils in zugeordneten Kontaktbuchsen sitzen, sodass jeder der Steckverbinder 42, 44, 46 jeweils drei separate elektrische Kontaktierungen ausbildet, d.h. eine erste Kontaktierung, eine zweite Kontaktierung und eine dritte Kontaktierung.

Eine Überwachungseinrichtung überwacht jede einzelne der elektrischen Kontaktierungen. So wird während der Übertragung einer Ladeleistung von der Quelle 20 zur Batterie 22 und auch beim Entladen der Batterie 22 jeweils ein im Bereich jeder Kontaktierung fließender Strom gemessen. Die Überwachungseinrichtung ist vorliegend durch die Strommessungen I1, I2, I3, I4, I5, I6, I7, I8, I9 repräsentiert.

Zur Überwachung der einzelnen Kontaktierungen eines jeweiligen Steckverbinders 42, 44, 46 wird überprüft, ob die einzelnen Teilströme der durch die einzelnen Kontaktbuchsen und Kontaktpins gebildeten Pfade in etwa gleich groß sind. Für das Beispiel des Steckverbinders 42 gilt, dass die Teilströme I1, I2 und I3 in etwa gleich groß sein sollten, soweit jede der Kontaktierungen fehlerfrei ist. Dies gilt analog für die Teilströme I4, I5, I6 des Steckverbinders 44 und für die Teilströme I7, I8, I9 des Steckverbinders 46.

So ergibt sich für den Steckerbinder 42 ein mittlerer Teilstrom Iₘ = (I1+I2+I3)/3, da ein Gesamtstrom I24 der ersten Verbindung 24 gleichmäßig auf alle drei Pfade des Steckverbinders 42 aufgeteilt werden sollte, soweit jede der Kontaktierungen fehlerfrei ist.

Stellt sich bei einer Überprüfung der Teilströme heraus, dass beispielsweise eine Abweichung ΔI = I1 - Iₘ des ersten Teilstroms des Steckverbinders 42 einen vorgegebenen Grenzwert überschreitet, ist die betreffende Kontaktierung fehlerhaft. Dies kann analog für jeden der Werte I2, I3, I4, I5, I6, I7, I8, I9 überprüft werden.

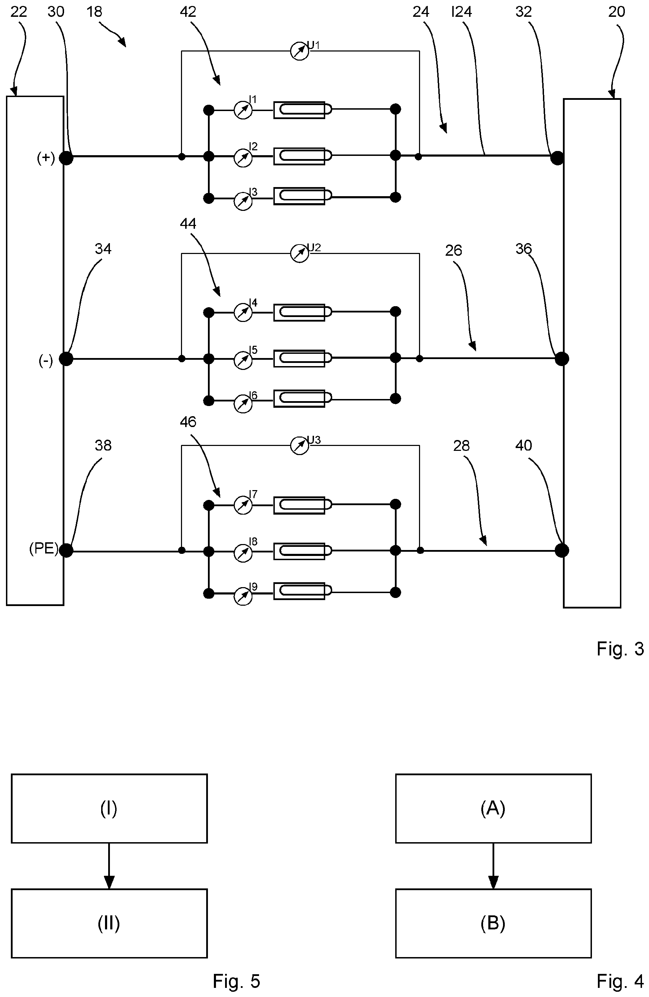

Fig. 3 zeigt eine alternative Ausgestaltung einer Überwachungseinrichtung, für die zusätzlich zu den genannten Teilströmen I1, I2, I3, I4, I5, I6, I7, I8, I9 eine Messung der jeweiligen Spannung U1, U2, U3 über dem jeweiligen Steckverbinder 42, 44, 46 erfolgt.

Aus der Spannung U1 lässt sich mit dem Teilstrom I1 die Leistung P1 = U1 * I1 oder der Widerstand R1 der ersten Kontaktierung des Steckverbinders 42 zu R1 = U1/I1 berechnen. Diese Berechnung kann analog für jeden der drei Pfade eines jeweiligen Steckverbinders 42, 44, 46 durchgeführt werden. Auch hier kann überprüft werden, ob eine entsprechende Leistung und/oder ein entsprechender Widerstand zu stark von einem vorgegebenen Sollwert abweicht bzw. eine vorgegebene Abweichung einen Schwellwert der Abweichung überschreitet.

Dadurch, dass für jede der Verbindungen 24, 26, 28 nicht nur ein Steckverbinder mit jeweils einem Kontaktpin und einer Kontaktbuchse, d. h. ein Steckverbinder mit nur einer Kontaktierung, verwendet wird, sondern die betreffenden Steckverbinder 42, 44, 46 jeweils drei Kontaktpins und drei zugeordnete Kontaktbuchsen haben, d. h. jeweils drei Kontaktierungen haben, können diese drei Kontaktierungen eines jeweiligen Steckverbinders 42, 44, 46 aufgrund ihrer Symmetrie dazu genutzt werden, sich wechselseitig zu überwachen und auf Funktion zu prüfen.

Es kann daher ein Verfahren angegeben werden, mit den Verfahrensschritten:
(A) Betreiben eines Batterieprüfstands 18, wobei eine Quelle 20 zum Bereitstellen einer elektrischen Ladeleistung mit einer zu prüfenden Batterie 22 verbunden ist, wobei eine erste Verbindung 24 zwischen einem ersten Pol 30 der Batterie 22 und einem ersten Pol 32 der Quelle 20 ausgebildet ist, wobei eine zweite Verbindung 26 zwischen einem zweiten Pol 34 der Batterie 22 und einem zweiten Pol 36 der Quelle 20 ausgebildet ist, wobei eine dritte Verbindung 28 zwischen einem dritten Pol 38 der Batterie 22 und einem dritten Pol 40 der Quelle 20 ausgebildet ist, wobei die erste Verbindung 24 einen ersten Steckverbinder 42 aufweist, wobei der erste Steckverbinder 42 drei Kontaktpins aufweist, wobei ein jeweiliger Kontaktpin im gesteckten Zustand jeweils in einer zugeordneten Kontaktbuchse des ersten Steckverbinders 42 sitzt und jeder Kontaktpin mit jeder Kontaktbuchse jeweils eine elektrische Kontaktierung ausbildet, wobei die zweite Verbindung 26 einen zweiten Steckverbinder 44 aufweist, wobei der zweite Steckverbinder 44 drei Kontaktpins aufweist, wobei ein jeweiliger Kontaktpin im gesteckten Zustand jeweils in einer zugeordneten Kontaktbuchse des zweiten Steckverbinders 44 sitzt und jeder Kontaktpin mit jeder Kontaktbuchse jeweils eine elektrische Kontaktierung ausbildet, und wobei die dritte Verbindung 28 einen dritten Steckverbinder 46 aufweist, wobei der dritte Steckverbinder 46 drei Kontaktpins aufweist, wobei ein jeweiliger Kontaktpin im gesteckten Zustand jeweils in einer zugeordneten Kontaktbuchse des zweiten Steckverbinders 44 sitzt und jeder Kontaktpin mit jeder Kontaktbuchse jeweils eine elektrische Kontaktierung ausbildet;
(B) Überwachen aller elektrischen Kontaktierungen mittels einer Überwachungseinrichtung.

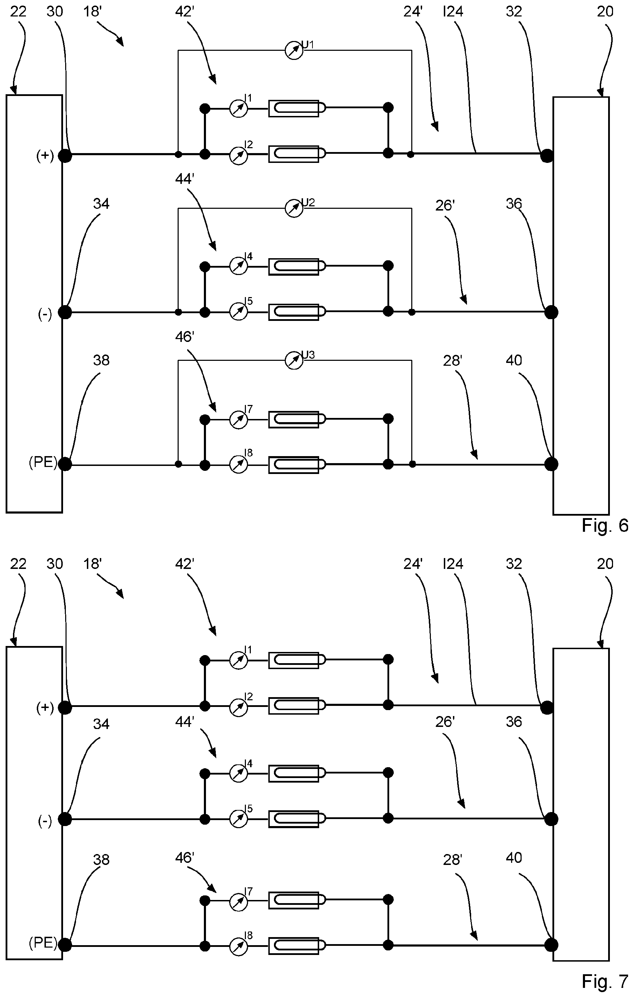

Die voranstehend beschriebene Vorgehensweise lässt sich gleichermaßen auf einen Batterieprüfstand 18' gemäß der Fig. 6 und Fig. 7 übertragen. Zur Vermeidung von Wiederholungen wird lediglich auf die Unterschiede zum voranstehend beschriebenen Ausführungsbeispiel eingegangen, wobei gleichen Merkmalen gleiche Bezugszeichen zugeordnet werden.

Der Batterieprüfstand 18' unterscheidet sich dadurch vom Batterieprüfstand 18, dass Verbindungen 24', 26', 28' mit lediglich zwei Pfaden, d.h. zwei Kontaktierungen, vorgesehen sind. Jede Steckverbindung 42', 44', 46' hat daher genau zwei Kontaktbuchsen und genau zwei Kontaktstifte.

Es kann daher ein Verfahren angegeben werden, mit den Verfahrensschritten:
(I) Betreiben eines Batterieprüfstands 18', wobei eine Quelle 20 zum Bereitstellen einer elektrischen Ladeleistung mit einer zu prüfenden Batterie 22 verbunden ist, wobei eine erste Verbindung 24' zwischen einem ersten Pol 30 der Batterie 22 und einem ersten Pol 32 der Quelle 20 ausgebildet ist, wobei eine zweite Verbindung 26' zwischen einem zweiten Pol 34 der Batterie 22 und einem zweiten Pol 36 der Quelle 20 ausgebildet ist, wobei eine dritte Verbindung 28' zwischen einem dritten Pol 38 der Batterie 22 und einem dritten Pol 40 der Quelle 20 ausgebildet ist, wobei die erste Verbindung 24' einen ersten Steckverbinder 42' aufweist, wobei der erste Steckverbinder 42' zwei Kontaktpins aufweist, wobei ein jeweiliger Kontaktpin im gesteckten Zustand jeweils in einer zugeordneten Kontaktbuchse des ersten Steckverbinders 42' sitzt und jeder Kontaktpin mit jeder Kontaktbuchse jeweils eine elektrische Kontaktierung ausbildet, wobei die zweite Verbindung 26' einen zweiten Steckverbinder 44' aufweist, wobei der zweite Steckverbinder 44' zwei Kontaktpins aufweist, wobei ein jeweiliger Kontaktpin im gesteckten Zustand jeweils in einer zugeordneten Kontaktbuchse des zweiten Steckverbinders 44' sitzt und jeder Kontaktpin mit jeder Kontaktbuchse jeweils eine elektrische Kontaktierung ausbildet, und wobei die dritte Verbindung 28' einen dritten Steckverbinder 46' aufweist, wobei der dritte Steckverbinder 46' zwei Kontaktpins aufweist, wobei ein jeweiliger Kontaktpin im gesteckten Zustand jeweils in einer zugeordneten Kontaktbuchse des zweiten Steckverbinders 44' sitzt und jeder Kontaktpin mit jeder Kontaktbuchse jeweils eine elektrische Kontaktierung ausbildet;
(II) Überwachen aller elektrischen Kontaktierungen mittels einer Überwachungseinrichtung.

### Bezugszeichen

- 2: Steckverbinder
- 4: Stecker
- 6: Gegenstecker
- 8: Kontaktpin
- 10: Kontaktbuchse
- 12: Leitung
- 14: Leitung
- 18, 18': Batterieprüfstand
- 20: Quelle
- 22: Batterie
- 24, 24': erste Verbindung
- 26, 26': zweite Verbindung
- 28, 28': dritte Verbindung
- 30: erster Pol der Batterie
- 32: erster Pol der Quelle
- 34: zweiter Pol der Batterie
- 36: zweiter Pol der Quelle
- 38: dritter Pol der Batterie
- 40: dritter Pol der Quelle
- 42, 42': erster Steckverbinder
- 44, 44': zweiter Steckverbinder
- 46, 46': dritter Steckverbinder
- I1: Strommessung
- I2: Strommessung
- I3: Strommessung
- I4: Strommessung
- I5: Strommessung
- I6: Strommessung
- I7: Strommessung
- I8: Strommessung
- I9: Strommessung
- U1: Spannungsmessung
- U2: Spannungsmessung
- U3: Spannungsmessung

## Patentansprüche

1. Batterieprüfstand,
- mit einer Quelle (20) zum Bereitstellen einer elektrischen Ladeleistung für eine zu prüfende Batterie (22),
- mit einer ersten Verbindung (24, 24') zum Verbinden eines ersten Pols (30) der Batterie (22) mit einem ersten Pol (32) der Quelle (20),
- mit einer zweiten Verbindung (26, 26') zum Verbinden eines zweiten Pols (34) der Batterie (22) mit einem zweiten Pol (36) der Quelle (20), wobei
- die erste Verbindung (24, 24') einen ersten Steckverbinder (42, 42') aufweist, wobei der erste Steckverbinder (42, 42') mindestens zwei Kontaktpins (8) aufweist, wobei ein jeweiliger Kontaktpin (8) im gesteckten Zustand jeweils in einer zugeordneten Kontaktbuchse (10) des ersten Steckverbinders (42, 42') sitzt und jeder Kontaktpin (8) mit jeder Kontaktbuchse (10) jeweils eine elektrische Kontaktierung ausbildet,
- die zweite Verbindung (26, 26') einen zweiten Steckverbinder (44, 44') aufweist, wobei der zweite Steckverbinder (44, 44') mindestens zwei Kontaktpins (8) aufweist, wobei ein jeweiliger Kontaktpin (8) im gesteckten Zustand jeweils in einer zugeordneten Kontaktbuchse (10) des zweiten Steckverbinders (44, 44') sitzt und jeder Kontaktpin (8) mit jeder Kontaktbuchse (10) jeweils eine elektrische Kontaktierung ausbildet, und
- mit einer Überwachungseinrichtung (I1, I2, I3, I4, I5, I6, I7, I8, I9, U1, U2, U3)
**dadurch gekennzeichnet, dass**
die Überwachungseinrichtung (I1, I2, I3, I4, I5, I6, I7, I8, I9, U1, U2, U3) zur Überwachung aller elektrischen Kontaktierungen vorgesehen ist.

2. Batterieprüfstand nach Anspruch 1,
**dadurch gekennzeichnet, dass**
- die Überwachungseinrichtung (I1, I2, I3, I4, I5, I6, I7, I8, I9, U1, U2, U3) zum Vergleich der jeweiligen über die einzelnen elektrischen Kontaktierungen fließenden Einzelströme ausgebildet ist,
- wobei jeder elektrischen Kontaktierung eine Einrichtung zur Strommessung zugeordnet ist.

3. Batterieprüfstand nach Anspruch 1 oder Anspruch 2,
**dadurch gekennzeichnet, dass**
- die Überwachungseinrichtung (I1, I2, I3, I4, I5, I6, I7, I8, I9, U1, U2, U3) zum Vergleich der jeweiligen an den einzelnen elektrischen Kontaktierungen gebildeten Kontaktwiderständen ausgebildet ist,
- wobei jeder elektrischen Kontaktierung eine Einrichtung zur Strommessung (I1, I2, I3, I4, I5, I6, I7, I8, I9) zugeordnet ist und wobei jedem Steckverbinder (42, 44, 42', 44') eine Einrichtung zur Spannungsmessung (U1, U2, U3) zugeordnet ist.

4. Batterieprüfstand nach einem der Ansprüche 1 - 3,
**dadurch gekennzeichnet, dass**
- der erste Steckverbinder (42') genau zwei Kontaktpins (8) und genau zwei Kontaktbuchsen (10) aufweist
und/oder
- der zweite Steckverbinder (44') genau zwei Kontaktpins (8) und genau zwei Kontaktbuchsen (10) aufweist.

5. Batterieprüfstand nach einem der Ansprüche 1 - 3,
**dadurch gekennzeichnet, dass**
- der erste Steckverbinder (42) genau drei Kontaktpins (8) und genau drei Kontaktbuchsen (10) aufweist
und/oder
- der zweite Steckverbinder (44) genau drei Kontaktpins und genau drei Kontaktbuchsen aufweist.

6. Batterieprüfstand nach einem der Ansprüche 1 - 3,
**dadurch gekennzeichnet, dass**
- der erste Steckverbinder (42, 42') bis zu zehn Kontaktpins (8) und bis zu zehn Kontaktbuchsen (10) aufweist
und/oder
- der zweite Steckverbinder (44. 44') bis zu zehn Kontaktpins (8) und bis zu zehn Kontaktbuchsen (10) aufweist.

7. Batterieprüfstand nach einem der voranstehenden Ansprüche 1 - 6,
**gekennzeichnet durch**
- eine dritte Verbindung (28, 28') zum Verbinden eines dritten Pols (38) der Batterie (22) mit einem dritten Pol (30) der Quelle (20),
- wobei die dritte Verbindung (28, 28') einen dritten Steckverbinder (46, 46') aufweist, wobei der dritte Steckverbinder (46, 46') mindestens zwei Kontaktpins (8) aufweist, wobei ein jeweiliger Kontaktpin (8) im gesteckten Zustand jeweils in einer zugeordneten Kontaktbuchse (10) des zweiten Steckverbinders sitzt und jeder Kontaktpin (8) mit jeder Kontaktbuchse (10) jeweils eine elektrische Kontaktierung ausbildet.

8. Batterieprüfstand nach einem der voranstehenden Ansprüche 1 - 7,
**dadurch gekennzeichnet, dass**
- jeder Steckverbinder (42, 42', 44, 44', 46, 46') einen Stecker (4) und einen Gegenstecker (6) aufweist,
- wobei der Stecker (4) die Kontaktpins (8) und der Gegenstecker (6) die Kontaktbuchsen (10) trägt oder
- wobei die Stecker (4) die Kontaktpins und der Gegenstecker (6) die Kontaktbuchsen (10) trägt.

9. Steckverbinder für einen Batterieprüfstand nach einem der voranstehenden Ansprüche 1 - 8,
- wobei der Steckverbinder (2, 42, 44, 46, 42', 44', 46') zum Verbinden eines Pols (30, 34, 38) der Batterie (22) mit einem Pol (32, 36, 40) der Quelle (20) eingerichtet ist,
- wobei der Steckverbinder (2, 42, 44, 46, 42', 44', 46') mindestens zwei Kontaktpins (8) aufweist,
- wobei ein jeweiliger Kontaktpin (8) im gesteckten Zustand jeweils in einer zugeordneten Kontaktbuchse (10) des Steckverbinders (2, 42, 44, 46, 42', 44', 46') sitzt und jeder Kontaktpin (8) mit jeder Kontaktbuchse (10) jeweils eine elektrische Kontaktierung ausbildet.

10. Verfahren, mit den Verfahrensschritten,
- Betreiben eines Batterieprüfstands,
- wobei eine Quelle (20) zum Bereitstellen einer elektrischen Ladeleistung mit einer zu prüfenden Batterie (22) verbunden ist,
- wobei eine erste Verbindung (24, 24') zwischen einem ersten Pol (30) der Batterie (22) und einem ersten Pol (32) der Quelle (20) ausgebildet ist, wobei
- eine zweite Verbindung (26, 26') zwischen einem zweiten Pol (34) der Batterie (22) und einem zweiten Pol (36) der Quelle (20) ausgebildet ist,
- die erste Verbindung (24, 24') einen ersten Steckverbinder (42, 42') aufweist, wobei der erste Steckverbinder (42, 42') mindestens zwei Kontaktpins aufweist, wobei ein jeweiliger Kontaktpin im gesteckten Zustand jeweils in einer zugeordneten Kontaktbuchse des ersten Steckverbinders (42, 42') sitzt und jeder Kontaktpin mit jeder Kontaktbuchse jeweils eine elektrische Kontaktierung ausbildet,
- wobei die zweite Verbindung (26, 26') einen zweiten Steckverbinder (44, 44') aufweist, wobei der zweite Steckverbinder (44, 44') mindestens zwei Kontaktpins (8) aufweist, wobei ein jeweiliger Kontaktpin (8) im gesteckten Zustand jeweils in einer zugeordneten Kontaktbuchse (10) des zweiten Steckverbinders (44, 44') sitzt und jeder Kontaktpin (10) mit jeder Kontaktbuchse (8) jeweils eine elektrische Kontaktierung ausbildet;
**dadurch gekennzeichnet, dass**
- ein Überwachen aller elektrischen Kontaktierungen mittels einer Überwachungseinrichtung erfolgt.

## Claims

1. A battery test stand,
- having a source (20) for providing electrical charging power to a battery (22) to be tested,
- having a first connection (24, 24') for connecting a first terminal (30) of the battery (22) to a first terminal (32) of the source (20),
- having a second connection (26, 26') for connecting a second terminal (34) of the battery (22) to a second terminal (36) of the source (20),
- wherein the first connection (24, 24') comprises a first connector (42, 42'), wherein the first connector (42, 42') comprises at least two contact pins (8), wherein, in the mated state, a respective contact pin (8) is seated in each case in an associated contact socket (10) of the first connector (42, 42') and each contact pin (8) forms in each case an electrical contact with each contact socket (10),
- wherein the second connection (26, 26') comprises a second connector (44, 44'), wherein the second connector (44, 44') comprises at least two contact pins (8), wherein, in the mated state, a respective contact pin (8) is seated in each case in an associated contact socket (10) of the second connector (44, 44') and each contact pin (8) forms in each case an electrical contact with each contact socket (10), and
- having a monitoring device (I1, I2, I3, I4, I5, I6, I7, I8, I9, U1, U2, U3)
**characterized in that**
- the monitoring device (I1, I2, I3, I4, I5, I6, I7, I8, I9, U1, U2, U3) is provided for monitoring all electrical contacts.

2. The battery test stand according to claim 1, **characterized in that**
- the monitoring device (I1, I2, I3, I4, I5, I6, I7, I8, I9, U1, U2, U3) is designed to compare the respective individual currents flowing across the individual electrical contacts,
- wherein a device for current measurement is assigned to each electrical contact.

3. The battery test stand according to claim 1 or claim 2, **characterized in that**
- the monitoring device (I1, I2, I3, I4, I5, I6, I7, I8, I9, U1, U2, U3) is designed to compare the respective contact resistances formed at the individual electrical contacts,
- wherein a device for current measurement (I1, I2, I3, I4, I5, I6, I7, I8, I9) is assigned to each electrical contact and wherein a device for voltage measurement (U1, U2, U3) is assigned to each connector (42, 44, 42', 44').

4. The battery test stand according to any one of the claims 1- 3, **characterized in that**
- the first connector (42') has exactly two contact pins (8) and exactly two contact sockets (10)
and/or
- the second connector (44') has exactly two contact pins (8) and exactly two contact sockets (10).

5. The battery test stand according to any one of the claims 1-3, **characterized in that**
- the first connector (42) has exactly three contact pins (8) and exactly three contact sockets (10)
and/or
- the second connector (44) has exactly three contact pins and exactly three contact sockets.

6. The battery test stand according to any one of the claims 1-3, **characterized in that**
- the first connector (42, 42') has up to ten contact pins (8) and up to ten contact sockets (10)
and/or
- the second connector (44. 44') has up to ten contact pins (8) and up to ten contact sockets (10).

7. The battery test stand according to any one of the preceding claims 1-6, **characterized by**
- a third connection (28, 28') for connecting a third terminal (38) of the battery (22) to a third terminal (30) of the source (20),
- wherein the third connection (28, 28') comprises a third connector (46, 46'), wherein the third connector (46, 46') comprises at least two contact pins (8), wherein, in the mated state, a respective contact pin (8) is seated in each case in an associated contact socket (10) of the second connector and each contact pin (8) forms in each case an electrical contact with each contact socket (10).

8. The battery test stand according to any one of the preceding claims 1-7, **characterized in that**
- each connector (42, 42', 44, 44', 46, 46') has a plug (4) and a mating plug (6),
- wherein the plug (4) carries the contact pins (8) and the mating plug (6) carries the contact sockets (10) or
- wherein the plug (4) carries the contact pins and the mating plug (6) carries the contact sockets (10).

9. A connector for a battery test stand according to any one of the preceding claims 1-8,
- wherein the connector (2, 42, 44, 46, 42', 44', 46') is adapted to connect a terminal (30, 34, 38) of the battery (22) to a terminal (32, 36, 40) of the source (20),
- wherein the connector (2, 42, 44, 46, 42', 44', 46') has at least two contact pins (8),
- wherein, in the mated state, a respective contact pin (8) is seated in each case in an associated contact socket (10) of the connector (2, 42, 44, 46, 42', 44', 46') and each contact pin (8) forms in each case a respective electrical contact with each contact socket (10).

10. A method, comprising the method steps of
- operating a battery test stand,
- wherein a source (20) for providing electrical charging power is connected to a battery (22) to be tested,
- wherein a first connection (24, 24') is formed between a first terminal (30) of the battery (22) and a first terminal (32) of the source (20),
- wherein a second connection (26, 26') is formed between a second terminal (34) of the battery (22) and a second terminal (36) of the source (20),
- wherein the first connection (24, 24') comprises a first connector (42, 42'), wherein the first connector (42, 42') comprises at least two contact pins, wherein, in the mated state, a respective contact pin is seated in each case in an associated contact socket of the first connector (42, 42') and each contact pin forms in each case an electrical contact with each contact socket,
- wherein the second connection (26, 26') comprises a second connector (44, 44'), wherein the second connector (44, 44') comprises at least two contact pins (8), wherein, in the mated state, a respective contact pin (8) is seated in each case in an associated contact socket (10) of the second connector (44, 44') and each contact pin (10) forms in each case an electrical contact with each contact socket (8); **characterized in that**
- all of electrical contacts are monitored by means of a monitoring device.

## Revendications

1. Banc d'essai pour batterie,
- avec une source (20) pour fournir une puissance de charge électrique à une batterie (22) à tester,
- avec une première connexion (24, 24') pour connecter un premier pôle (30) de la batterie (22) à un premier pôle (32) de la source (20),
- avec une deuxième connexion (26, 26') pour relier un deuxième pôle (34) de la batterie (22) à un deuxième pôle (36) de la source (20),
où
- la première connexion (24, 24') comporte un premier connecteur enfichable (42, 42'), le premier connecteur enfichable (42, 42') comportant au moins deux broches de contact (8), une broche de contact respective (8) étant logée à l'état enfiché dans une douille de contact associée (10) du premier connecteur enfichable (42, 42') et chaque broche de contact (8) formant avec chaque douille de contact (10) une
- la deuxième connexion (26, 26') comporte un deuxième connecteur (44, 44'), le deuxième connecteur (44, 44') comportant au moins deux broches de contact (8), une broche de contact (8) respective étant logée à l'état enfiché dans une douille de contact (10) associée du deuxième connecteur (44, 44') et chaque broche de contact (8) formant avec chaque douille de contact (10) une connexion électrique,
et
- avec un dispositif de surveillance (I1, 12, 13, 14, 15, 16, 17, 18, 19, U1, U2, U3) **caractérisé en ce que** le dispositif de surveillance (I1, 12, 13, 14, 15, I6, 17, I8, 19, U1, U2, U3) est prévu pour surveiller tous les contacts électriques.

2. Banc d'essai pour batterie selon la revendication 1,
**caractérisé en ce que**
- le dispositif de surveillance (I1, 12, 13, 14, 15, I6, 17, 18, 19, U1, U2, U3) est conçu pour comparer les courants individuels circulant respectivement à travers les différents contacts électriques,
- un dispositif de mesure du courant étant associé à chaque contact électrique.

3. Banc d'essai pour batterie selon la revendication 1 ou la revendication 2,
**caractérisé en ce que**
- le dispositif de surveillance (I1, 12, 13, 14, 15, I6, 17, 18, 19, U1, U2, U3) est conçu pour comparer les résistances de contact respectives formées au niveau des différents contacts électriques,
- chaque contact électrique étant associé à un dispositif de mesure du courant (I1, I2, I3, I4, I5, I6, I7, I8, I9) et chaque connecteur (42, 44, 42', 44') étant associé à un dispositif de mesure de la tension (U1, U2, U3).

4. Banc d'essai pour batterie selon l'une des revendications 1 à 3,
**caractérisé en ce que**
- le premier connecteur enfichable (42') comporte exactement deux broches de contact (8) et exactement deux douilles de contact (10)
et/ou
- le deuxième connecteur enfichable (44') comporte exactement deux broches de contact (8) et exactement deux douilles de contact (10).

5. Banc d'essai pour batterie selon l'une des revendications 1 à 3,
**caractérisé en ce que**
- le premier connecteur (42) comporte exactement trois broches de contact (8) et exactement trois douilles de contact (10)
et/ou
- le deuxième connecteur (44) comporte exactement trois broches de contact et exactement trois douilles de contact.

6. Banc d'essai pour batterie selon l'une des revendications 1 à 3,
**caractérisé en ce que**
- le premier connecteur (42, 42') comporte jusqu'à dix broches de contact (8) et jusqu'à dix douilles de contact (10)
et/ou
- le deuxième connecteur (44, 44') comporte jusqu'à dix broches de contact (8) et jusqu'à dix douilles de contact (10).

7. Banc d'essai pour batterie selon l'une des revendications 1 à 6 ci-dessus,
**caractérisé par**
- une troisième connexion (28, 28') pour relier un troisième pôle (38) de la batterie (22) à un troisième pôle (30) de la source (20),
- la troisième connexion (28, 28') comportant un troisième connecteur enfichable (46, 46'), le troisième connecteur enfichable (46, 46') comportant au moins deux broches de contact (8),
une broche de contact respective (8) étant logée à l'état enfiché dans une douille de contact associée (10) du deuxième connecteur et chaque broche de contact (8) formant un contact électrique avec chaque douille de contact (10).

8. Banc d'essai pour batterie selon l'une des revendications 1 à 7 précédentes,
**caractérisé en ce que**
- chaque connecteur (42, 42', 44, 44', 46, 46') comporte une fiche (4) et une contre-fiche (6),
- la fiche mâle (4) portant les broches de contact (8) et la fiche femelle (6) portant les douilles de contact (10) ou
- les fiches mâles (4) portant les broches de contact et la fiche femelle (6) portant les douilles de contact (10).

9. Connecteur pour un banc d'essai de batterie selon l'une des revendications 1 à 8 ci-dessus,
- le connecteur (2, 42, 44, 46, 42', 44', 46') étant conçu pour relier un pôle (30, 34, 38) de la batterie (22) à un pôle (32, 36, 40) de la source (20),
- le connecteur (2, 42, 44, 46, 42', 44', 46') comportant au moins deux broches de contact (8),
- chaque broche de contact (8) étant logée, à l'état enfiché, dans une douille de contact (10) associée du connecteur (2, 42, 44, 46, 42', 44', 46')
et chaque broche de contact (8) formant une connexion électrique avec chaque douille de contact (10).

10. Procédé comprenant les étapes suivantes :
- faire fonctionner un banc d'essai pour batteries,
- une source (20) destinée à fournir une puissance de charge électrique étant reliée à une batterie (22) à tester,
- une première connexion (24, 24') étant formée entre un premier pôle (30) de la batterie (22) et un premier pôle (32) de la source (20),
dans lequel
- une deuxième connexion (26, 26') est formée entre un deuxième pôle (34) de la batterie (22) et un deuxième pôle (36) de la source (20),
- la première connexion (24, 24') comporte un premier connecteur enfichable (42, 42') , le premier connecteur enfichable (42, 42') comportant au moins deux broches de contact, une broche de contact respective étant logée à l'état enfiché dans une douille de contact associée du premier connecteur enfichable (42, 42') et chaque broche de contact formant avec chaque douille de contact une connexion électrique,
- la deuxième connexion (26, 26') comportant un deuxième connecteur enfichable (44, 44'), le deuxième connecteur enfichable (44, 44') comportant au moins deux broches de contact (8), chaque broche de contact (8) étant logée à l'état enfiché dans une douille de contact (10) associée du deuxième connecteur enfichable (44, 44') et chaque broche de contact (10) forme respectivement un contact électrique avec chaque douille de contact (8) ; **caractérisé en ce que**
- une surveillance de tous les contacts électriques est effectuée au moyen d'un dispositif de surveillance.
